# EUROPÄISCHE PATENTANMELDUNG

(11) **EP 0 555 530 A2**
(43) Veröffentlichungstag der Anmeldung: **18.08.1993**
(21) Anmeldenummer: 92119317.3
(22) Anmeldetag: 12.11.1992
(51) Int. Cl.: G01R 31/04

(54) **Einrichtung zum Prüfen eines mit Kabeln versehenen Steckers**

(30) Priorität: 11.01.1992 DE 9200253 U
(71) Anmelder: TSK Prüfsysteme für elektrische Komponenten GmbH, 32457 Porta Westfalica (DE)
(72) Erfinder: Khalil, Girgis Amin, W-4800 Bielefeld 1 (DE); Mohme, Heinrich, W-4973 Vlotho (DE)
(74) Vertreter: Stracke, Alexander, Dipl.-Ing.

(57) **Zusammenfassung**

Mit derartigen Einrichtungen werden vorzugsweise im Automobilbau verwendete Kabel bzw. Stecker auf Verrastungsfehler geprüft. Um eine Verwechslung bei der Montage zu vermeiden, sind die verschiedenen Stecker in ihrer Form unterschiedlich gestaltet, wobei sie jeweils nur in ein entsprechend angepaßtes Aufnahmeteil eingesteckt werden können. Dies bedeutet, daß praktisch für jeden Stecker eine eigene Einrichtung hergestellt werden muß, die aufgrund vieler weiterer, benötigter Bauteile in ihrer Herstellung relativ teuer sind, so daß sich durch die Vielzahl der vorkommenden unterschiedlicher Stekker ein erheblicher Kostenaufwand ergibt. Mit Hilfe der Erfindung soll die Einrichtung kostengünstiger hergestellt werden und ein einfacheres Auswechseln möglich sein. Dazu ist vorgesehen, daß das Aufnahmeteil (2) herausnehmbar und lagearretiert in einem Gehäuse (1) angeordnet ist.

Durch die Erfindung ist somit lediglich ein Auswechseln des Aufnahmeteils erforderlich, während die übrigen, zu der Einrichtung gehörenden Bauteile für alle einsteckbaren Aufnahmeteile einsetzbar sind. Hieraus ergibt sich naturgemäß eine erhebliche Kosteneinsparung.

## Beschreibung

Die vorliegende Erfindung betrifft eine Einrichtung zum Prüfen eines mit Kabeln versehenen Steckers auf Verrastungsfehler und/oder Kontaktierungsfehler gemäß dem Oberbegriff des Anspruches 1.

Die mittels einer derartigen Einrichtung geprüften Kabel bzw. Stecker finden vorzugsweise im Automobilbau Verwendung, wo sie zu Kabelbäumen zusammengefaßt mit zugeordneten Kupplungsstücken verbunden werden.

Um eine Verwechslung bei der Montage, also beim Zusammenstecken zu vermeiden, sind die verschiedenen Stecker in ihrer Form so unterschiedlich gestaltet, daß sie nur in das entsprechend zugeordnete Aufnahmeteil eingesteckt werden können.

Zur vollen Funktionsfähigkeit der Einrichtung sind bestimmte Bauteile erforderlich. So muß beispielsweise eine Haltevorrichtung vorgesehen sein, die mechanisch oder manuell betätigbar ist und mit der der in die Ausnehmung eingeführte Stecker während des Prüfvorganges gehalten wird. Dabei ist eine derartige Haltevorrichtung integraler Bestandteil des Aufnahmeteiles.

Da für jede Steckerform, also für jede unterschiedliche Außenkontur ein eigenes Aufnahmeteil hergestellt werden muß, bedeutet dies bislang, daß praktisch für jeden Stecker eine eigene Einrichtung herzustellen ist, die auch die genannten erforderlichen Bauteile wie die Haltevorrichtung beinhaltet.

Bei der Vielzahl der vorkommenden unterschiedlichen Stecker ist dies mit einem erheblichen Kostenaufwand verbunden, wobei nicht nur die Herstellung der Einrichtung einer wirtschaftlich optimalen Verwendung im Wege steht, sondern auch ein bedarfsweises Auswechseln der Einrichtungen.

Der vorliegenden Erfindung liegt daher die Aufgabe zugrunde, eine Einrichtung der gattungsgemäßen Art so zu gestalten, daß sie kostengünstiger herstellbar ist und ein einfaches Auswechseln je nach Erfordernis möglich wird.

Diese Aufgabe wird erfindungsgemäß durch die im kennzeichnenden Teil des Anspruches 1 genannten Merkmale gelöst.

Durch diese konstruktiven Maßnahmen ist es nun möglich, ausschließlich das die Ausnehmung zur Aufnahme des Steckers aufweisende Aufnahmeteil herzustellen und je nach zu prüfendem Stecker auszuwechseln.

Dabei dient das Aufnahmeteil ausschließlich der Steckeraufnahme, während die übrigen für eine Funktion erforderlichen Bauteile, wie die Haltevorrichtung, in dem Gehäuse untergebracht werden.

Alle Aufnahmeteile können in das Gehäuse eingesetzt werden, wobei in den Aufnahmeteilen Durchbrechungen vorzusehen sind, durch die die Haltevorrichtung den einliegenden Stecker ergreifen kann.

Zweckmäßig ist es, für alle Aufnahmeteile die gleiche Außenkontur vorzusehen, die im wesentlichen mit der Außenkontur einer Einlaßöffnung des Gehäuses übereinstimmt.

Dabei ist es vorteilhaft, eine Verdrehsicherung des Aufnahmeteiles durch die Formgebung der Einlaßöffnung einerseits und des Aufnahmeteiles andererseits vorzusehen.

Eine besonders einfache Herstellung des Aufnahmeteiles ist dann möglich, wenn dieses aus einem Kunststoff hergestellt wird, wobei die Ausnehmung eingefräst werden kann.

Ein Gedanke der Erfindung sieht vor, daß die Prüfnadelplatte fester Bestandteil des Aufnahmeteiles ist, d.h., daß die Prüfnadelplatte und das Aufnahmeteil im übrigen einstückig ausgebildet sind.

Denkbar ist aber auch, daß die Prüfnadelplatte als separates Teil im Gehäuse einliegt und mit diesem entweder fest oder lösbar verbunden ist.

Auch können erforderliche elektrische Steckverbindungen unmittelbar an dem Aufnahmeteil befestigt sein, beispielsweise ein Teil einer Steckkupplung, das mit dem anderen, im Gehäuse festgelegten Kupplungsteil beim Einstecken des Aufnahmeteiles in die Einlaßöffnung verbunden wird.

Ein weiterer Gedanke der Erfindung sieht vor, daß Mittel vorgesehen sind, mit denen ein lagegenaues Einbringen des Aufnahmeteiles gesichert ist.

Weitere vorteilhafte Ausgestaltungen der Erfindung sind in den Unteransprüchen gekennzeichnet.

Ein Ausführungsbeispiel der Erfindung wird nachfolgend anhand der beigefügten Zeichnungen beschrieben.

Es zeigen:

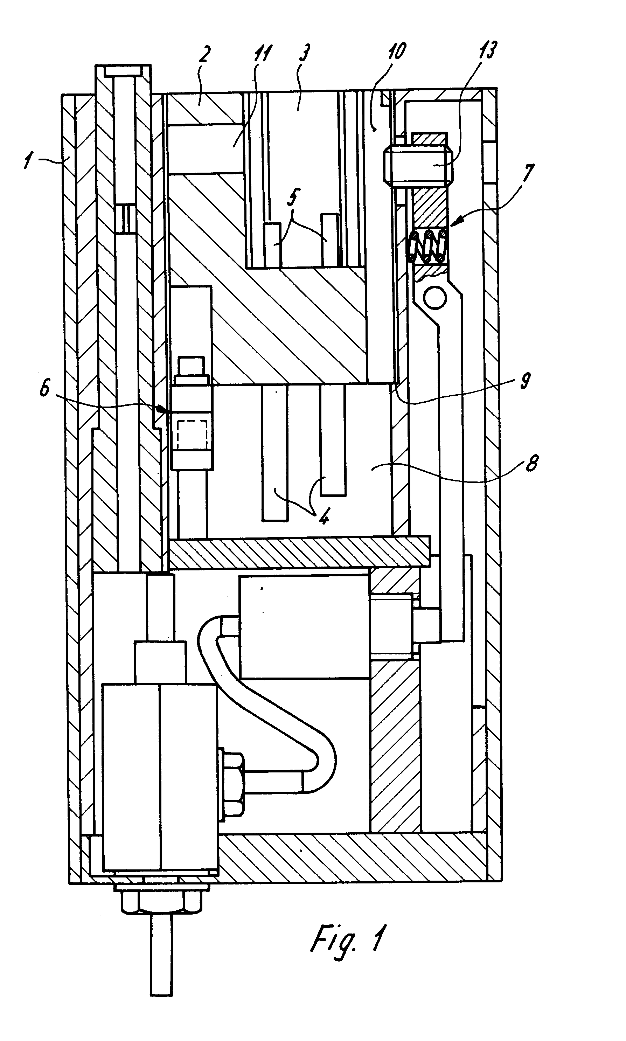

Fig. 1 einen Längsschnitt durch eine erfindungsgemäße Einrichtung,
Fig. 2 eine Draufsicht auf die Einrichtung.

In den Figuren eine Einrichtung zum Prüfen eines mit Kabeln versehenen Steckers auf Verrastungsfehler und/oder Kontaktierungsfehler gezeigt, die ein Aufnahmeteil 2 aufweist, in der eine Ausnehmung 3 vorgesehen ist, in die ein nicht dargestellter Stecker einführbar ist. Dabei entspricht die Querschnittskontur der Ausnehmung 3 der des Steckers.

Das Aufnahmeteil 2 ist herausnehmbar und lagearretiert in einem Gehäuse 1 angeordnet, wobei das Gehäuse 1 zur Aufnahme des Aufnahmeteiles 2 eine Einlaßöffnung 8 besitzt, in die das Aufnahmeteil 2 lagegenau einschiebbar ist.

Zu dieser lagegenauen Einschiebung weist das Aufnahmeteil 2 seitlich eine Längsführung 10 auf, die nach unten hin offen ist und in der ein Stift 13 geführt ist, der Bestandteil einer Haltevorrichtung 7 ist, mit der der in der Ausnehmung 3 liegende Stecker gehalten wird. Dabei kann die Haltevorrichtung 7 beispielsweise elektromagnetisch betätigbar sein.

Den Bodenbereich des Aufnahmeteiles 2 bildet im vorliegenden Ausführungsbeispiel eine Prüfnadelplatte, in der Hülsen 4 festgelegt sind, die der Aufnahme von Prüfnadeln 5 dienen.

Zur Begrenzung der Einschubtiefe des Aufnahmeteiles 2 ist in der Einlaßöffnung ein Absatz 9 vorgesehen, an dem das Aufnahmeteil 2 anliegt.

An seiner Unterseite weist das Aufnahmeteil 2 ein Steckverbinderteil auf, das gemeinsam mit einem weiteren Steckverbinderteil, das in der Einlaßöffnung 8 angeordnet und im Gehäuse festgelegt ist, eine elektrische Steckverbindung 6 bildet.

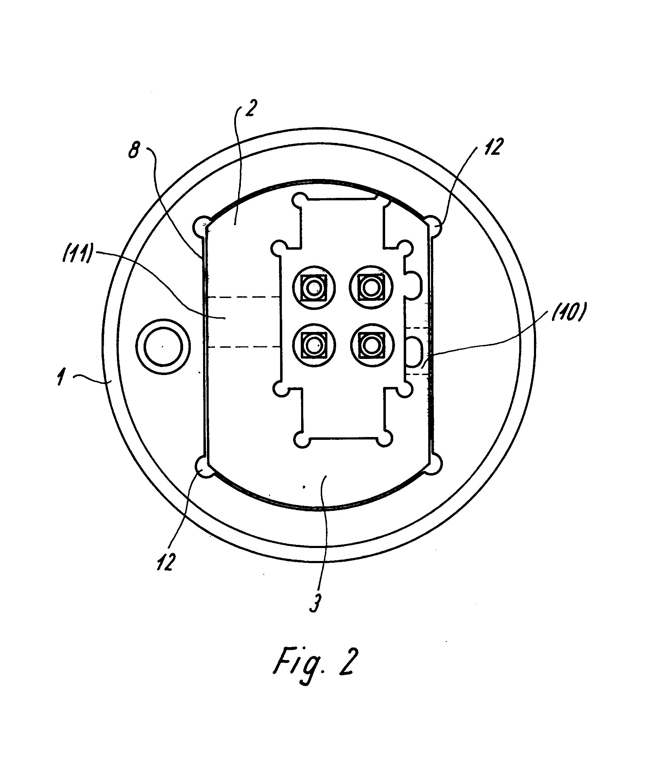

Wie in der Fig. 2 sehr deutlich zu erkennen ist, ist die Querschnittskontur des Aufnahmeteiles 2 im wesentlichen entsprechend der der Einlaßöffnung 8 ausgebildet, wobei sich im beschriebenen Beispiel die Kontur zusammensetzt aus zwei gegenüberliegenden, konvex geformten und zwei sich gleichfalls gegenüberliegenden parallel zueinander verlaufenden Begrenzungsflächen.

Im Eckbereich der Begrenzungsflächen weist die Einlaßöffnung 8 Staubecken 12 auf.

Zur besseren Entnahme des Aufnahmeteiles 2 ist eine Werkzeugaufnahme 11 vorgesehen, in die ein entsprechend geformtes Werkzeug einführbar ist, so daß das Aufnahmeteil leicht aus der Einlaßöffnung 8 herausziehbar ist.

## Patentansprüche

1. Einrichtung zum Prüfen eines mit Kabeln versehenen Steckers auf Verrastungs- und/oder Kontaktierungsfehler, mit einem Aufnahmeteil, das eine der Außenkontur eines bestimmten Steckers angepaßte Ausnehmung aufweist, wobei eine seitlich in die Ausnehmung einrückbare Halteeinrichtung vorgesehen ist, mit der der in die Ausnehmung eingesteckte Stecker festsetzbar ist, und einer im Bodenbereich des Aufnahmeteiles vorgesehenen Prüfnadelplatte, in der Hülsen zur Aufnahme von Prüfnadeln festgelegt sind, dadurch gekennzeichnet, daß das Aufnahmeteil (2) herausnehmbar und lagearretiert in einem Gehäuse (1) angeordnet ist.

2. Einrichtung nach Anspruch 1, dadurch gekennzeichnet, daß das Aufnahmeteil (2) zur lagegenauen Einführung mit einer zum Bodenbereich hin offenen Längsführung (10) versehen ist, in die ein Stift (13) einer im Gehäuse (1) angeordneten Haltevorrichtung (7) eingreift.

3. Einrichtung nach Anspruch 1, dadurch gekennzeichnet, daß die Prüfnadelplatte und das Aufnahmeteil (2) im übrigen einstückig ausgebildet sind.

4. Einrichtung nach Anspruch 1, dadurch gekennzeichnet, daß die Prüfnadelplatte mit dem Gehäuse fest verbunden ist.

5. Einrichtung nach Anspruch 1, dadurch gekennzeichnet, daß sowohl das Aufnahmeteil (2) als auch die Prüfnadelplatte getrennt herausnehmbar sind.

6. Einrichtung nach Anspruch 1, dadurch gekennzeichnet, daß das Aufnahmeteil (2) mit einer Werkzeugaufnahme (11) versehen ist.

7. Einrichtung nach Anspruch 1, dadurch gekennzeichnet, daß das Aufnahmeteil (2) verdrehsicher in dem Gehäuse (1) gehalten ist.
